# EUROPEAN PATENT APPLICATION

(11) **EP 4 848 943 A1**
(43) Date of publication of application: **02.12.2026**
(21) Application number: 26181141.8
(22) Date of filing: 26.05.2026
(51) Int. Cl.: H10D 84/83, H10D 30/65, H10D 64/00, H10D 84/80

(54) **MOSFET STRUCTURE**

(30) Priority: 27.05.2025 FR 2505728
(71) Applicant: STMicroelectronics International N.V., 1228 Plan-les-Ouates, Geneva (CH)
(72) Inventor: PAVLIN, Antoine, 13540 PUYRICARD (FR); MASOERO, Lia, 13006 MARSEILLE (FR); ZOINO, Stefano, 13090 AIX-EN-PROVENCE (FR)
(74) Representative: Cabinet Beaumont

(57) **Abstract**

The present disclosure relates to a MOSFET structure (300) formed on and in a semiconductor substrate (101), the MOSFET structure comprising:
- a main MOSFET (31) including a semiconductor isolation region (102) forming a base of a parasitic bipolar transistor with the semiconductor substrate and another semiconductor region or layer of the main MOSFET;
- an integrated electronic circuit (32, 310) configured to:
couple the semiconductor isolation region (102) to the drain region (D1) of the main MOSFET in a reverse-conducting operation of the MOSFET; and
couple the semiconductor isolation region (102) to the source region (S1) of the main MOSFET in a normal operation of the MOSFET.

## Description

### Technical field

The present disclosure relates generally to electronic devices and, more particularly, to metal oxide semiconductor field effect transistor (MOSFET) structures.

In particular, the present disclosure relates to a MOSFET structure including a parasitic bipolar transistor.

### Background art

Some MOSFET structures are lateral diffusion MOSFET (LDMOS) structures. In LDMOS structures, the MOSFET may be formed in a first semiconductor layer of a first conductivity type isolated from a semiconductor substrate of the first conductivity type by a second semiconductor layer of a second conductivity type opposite the first conductivity type, such that a parasitic bipolar transistor is formed.

The parasitic bipolar transistor may degrade the performances of the MOSFET, for example in terms of current and/or voltage.

The LDMOS may have a planar gate over the drain, source and channel regions. The LDMOS may be a trench LDMOS, or TLDMOS, in which the gate is a vertical gate in a trench.

### Summary of Invention

There is a need to improve at least certain aspects of MOSFET structures, for example to address the parasitic bipolar issues in a MOSFET structure, and to increase the performances of the MOSFET structure.

One embodiment addresses all or some of the drawbacks of known MOSFET structures.

One embodiment provides a MOSFET structure formed on and in a semiconductor substrate, the MOSFET structure comprising:
- a main MOSFET including a semiconductor isolation region forming a base of a parasitic bipolar transistor with the semiconductor substrate and another semiconductor region or layer of the main MOSFET;
- an integrated electronic circuit configured to:
   couple the semiconductor isolation region to a drain region of the main MOSFET in a reverse-conducting operation of the MOSFET; and
   couple the semiconductor isolation region to the source region of the main MOSFET in a normal operation of the MOSFET.

In an embodiment, the integrated electronic circuit is configured to detect if the gate of the main MOSFET is activated or deactivated, and to
- couple the semiconductor isolation region to the drain region of the main MOSFET if the gate is activated; and
- couple the semiconductor isolation region to the source region of the MOSFET if the gate is deactivated.

In an embodiment, the semiconductor substrate is of a first conductivity type, the semiconductor isolation region is of the second conductivity type opposite the first conductivity type, and the MOSFET structure further includes a semiconductor layer of the first conductivity type, the semiconductor isolation region being located between the semiconductor substrate and the semiconductor layer, for example an active area of the main MOSFET is formed in the semiconductor layer.

In an embodiment, the MOSFET structure further comprises at least one inner trench in the semiconductor layer from an upper face of the semiconductor layer, the gate of the main MOSFET being a vertical gate having a gate region isolated by a gate insulating layer in the at least one inner trench.

In an embodiment, the gate region is positioned over a conductive element, for example a field plate, isolated by a first insulating layer in the inner trench and isolated from the gate region by a second insulation layer.

In an embodiment, the integrated electronic circuit comprises an auxiliary MOSFET and a resistance, the gate of the auxiliary MOSFET being coupled to, or being common with, the gate of the main MOSFET, an auxiliary drain region of the auxiliary MOSFET being coupled to the drain region of the main MOSFET, an auxiliary source region of the auxiliary MOSFET being coupled to the semiconductor isolation region, and the source region of the main MOSFET being coupled to the semiconductor isolation region through the resistance.

The auxiliary source region of the auxiliary MOSFET is thus coupled to the source region of the main MOSFET through the resistance.

The auxiliary drain region, the drain region of the main MOSFET, the auxiliary source region and the source region of the main MOSFET are preferably formed in the semiconductor layer.

In an embodiment, the resistance is comprised between the resistance of the main MOSFET in the activated state and the resistance of the main MOSFET in the deactivated state.

For example, the resistance is comprised between 100Ω (Ohms) and 100kΩ.

In an embodiment, the auxiliary MOSFET is similar to the main MOSFET, for example the main and auxiliary MOSFETs are lateral diffusion MOSFETs (LDMOS) or trench lateral diffusion MOSFETs (TLDMOS).

In an embodiment:
- the source region of the main MOSFET comprises a main body region of the second conductivity type, and a main source contact region of the first conductivity type in the main body region and flush with an upper face of the semiconductor layer;
- the drain region of the main MOSFET comprises a main low doped drain region of the first conductivity type, and a main drain contact region in the main low doped drain region and flush with the upper face of the semiconductor layer; the main channel formation region of the main MOSFET being formed in the main body region and being of the second conductivity type;
- the auxiliary source region comprises an auxiliary body region of the second conductivity type, and an auxiliary source contact region of the first conductivity type in the auxiliary body region and flush with the upper face of the semiconductor layer;
- the auxiliary drain region comprises an auxiliary low doped drain region of the first conductivity type, and an auxiliary drain contact region in the auxiliary low doped drain region and flush with the upper face of the semiconductor layer; and the auxiliary channel region of the auxiliary MOSFET being formed in the auxiliary body region and being of the second conductivity type.

In an embodiment, the areas of the semiconductor layer that are delimited by the at least one inner trench form active areas of the main and auxiliary MOSFETs.

In an embodiment, the main MOSFET and the auxiliary MOSFET are coupled to a same battery at a lower face of the semiconductor substrate.

In an embodiment, the gate region is common to the main MOSFET and the auxiliary MOSFET.

In an embodiment, the auxiliary MOSFET is a plurality of auxiliary MOSFETs each extending in a first direction substantially parallel to a plane of the semiconductor substrate, the main MOSFET is a plurality of main MOSFETs extending in the first direction, the main MOSFETs being located between the auxiliary MOSFETs in a second direction substantially orthogonal to the first direction and substantially parallel to the plane.

In an embodiment, the resistance is an integrated diffused resistance.

An embodiment provides an electronic device comprising a semiconductor substrate and at least one MOSFET structure as described before formed on and in the semiconductor substrate.

An embodiment provides a method for using the MOSFET structure as described before, the using method comprising using the integrated electronic circuit for:
coupling the semiconductor isolation region to the drain region of the main MOSFET in a reverse-conducting operation of the MOSFET; and
coupling the semiconductor isolation region to the source region of the main MOSFET in a normal operation of the MOSFET.

In an embodiment, the integrated electronic circuit detects if the gate of the main MOSFET is activated or deactivated, and:
- couples the semiconductor isolation region to the drain region of the main MOSFET if the gate is activated; or
- couples the semiconductor isolation region to the source region of the main MOSFET if the gate is deactivated.

### Brief description of drawings

The foregoing features and advantages, as well as others, will be described in detail in the following description of specific embodiments given by way of illustration and not limitation with reference to the accompanying drawings, in which:
Figure 1A, Figure 1B and Figure 1C are cross-section views schematically illustrating an example of a MOSFET structure;
Figure 2 shows targeted and measured curves representing the drain output current density of the MOSFET structure of Figure 1A as a function of the output battery voltage when the MOSFET structure operates in a current-recirculation operation;
Figure 3A is a three-dimensional view partially illustrating a MOSFET structure according to an embodiment;
Figure 3B and Figure 3C are different cross-sections views illustrating an inner trench of the MOSFET structure of Figure 3A;
Figure 4 are circuit diagrams illustrating exemplary functioning of MOSFET structures according to embodiments;
Figure 5 is a top view illustrating a MOSFET structure according to another embodiment and an electronic device according to an embodiment.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. In particular, the steps for manufacturing the MOSFET structures and the main and auxiliary MOSFETs are not described, being implementable with usual methods of microelectronics. Similarly, all the details of the MOSFET structures and the main and auxiliary MOSFETs have not been described, being within the abilities of those skilled in the art in the field of transistors.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "upper", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10 % or 10°, and preferably within 5 % or 5°.

In the following disclosure, when reference is made to an "active area", it is referred to a semiconductor area of at least one transistor, for example, delimited by one or more trenches. In lateral diffusion transistors, an active area typically comprises at least one source region, at least one drain region, and at least one channel region, between adjacent source and drain regions. The active area may be formed in a semiconductor substrate, in a well formed in a semiconductor substrate, or in a semiconductor layer formed over the semiconductor substrate.

In the following disclosure, a MOSFET can also be referred to as a MOS transistor, a MOSFET structure refers to a semiconductor structure that comprises one or a plurality of MOSFET (s), and a MOSFET cell is a cell of one or a plurality of MOSFET(s).

In the following disclosure, when reference is made to a "substrate", it is referred to a semiconductor substrate, and when reference is made to a "region", it is referred to a semiconductor region, except for a gate region that may be a metallic and/or semiconductor region.

In the following disclosure, a length corresponds to a dimension in a first direction, corresponding to the X direction indicated in the drawings, of a plane substantially parallel to the plane XY of the substrate. The first direction is parallel to the conduction direction of the transistors. A channel length of a transistor for example corresponds to the distance between a source region and a drain region of the transistor. A width corresponds to a dimension in a second direction of the main plane, orthogonal to the X direction, corresponding to the Y direction indicated in the drawings. A thickness or a depth corresponds to a dimension in the direction perpendicular to the main plane, for example, a vertical direction, corresponding to the Z direction indicated in the drawings. The term "transversal" refers to the width direction (Y direction) and the term "longitudinal" or "lateral" refers to the length direction (X direction).

In the following disclosure, when reference is made to a conductive element, it is referred to an electrically conductive element. Similarly, when reference is made to an insulating element, it is referred to an electrically insulating element.

In the following disclosure:
- a normal operation of a MOSFET means an operation in which the current circulates in the normal direction of the MOSFET, that is: for the N-type the current circulates from the drain D to the source S, and for the P-type the current circulates from the source S to the drain D;
- a current-recirculation operation, or reverse-conducting operation, of the MOSFET means an operation in which the current circulates in the reverse direction of the MOSFET, that is: for the N-type the current circulates from the source S to the drain D, and for the P-type the current circulates from the drain D to the source S.

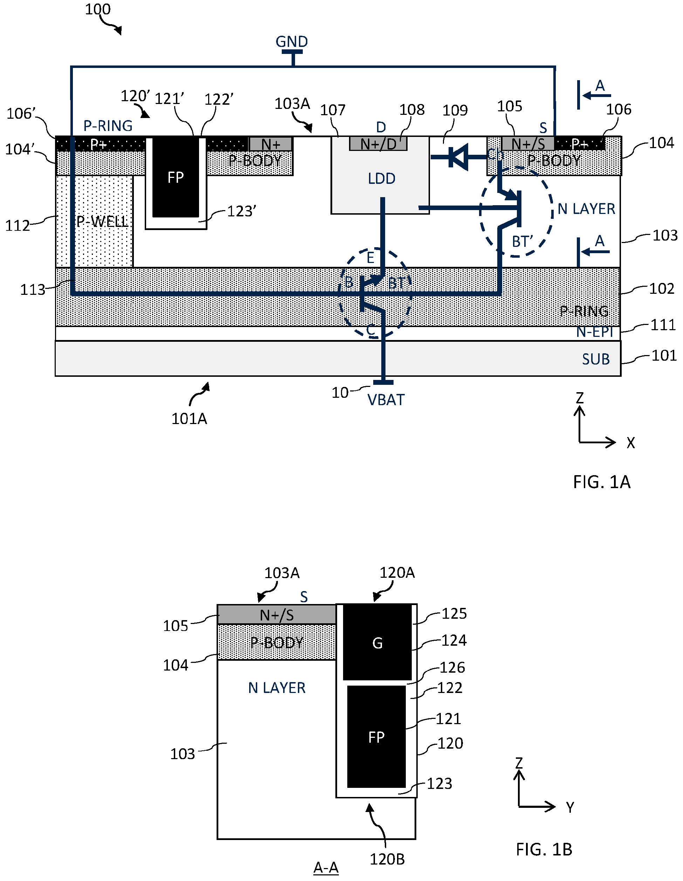

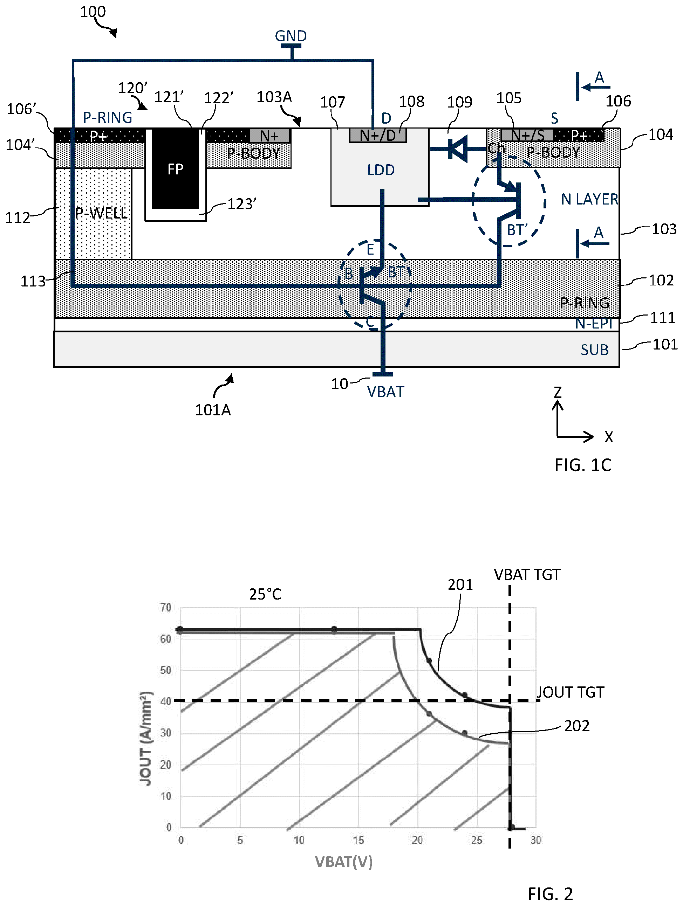

Figure 1A, Figure 1B and Figure 1C are cross-section views schematically illustrating an example of a MOSFET structure 100. Figures 1A and 1C are longitudinal cross-section views and Figure 1B is a transversal cross-section view in the A-A plane shown in Figures 1A and 1B.

The MOSFET structure 100 of Figures 1A-1C is a trench lateral diffusion MOSFET (TLDMOS), and is formed on and in a semiconductor substrate 101 (SUB).

The semiconductor substrate 101 is of a first conductivity type.

In the example of Figures 1A-1C, the MOSFET is a NMOS transistor, the first conductivity type is the N-type and the second conductivity type is the P-type. In a variant, the first conductivity type could be the P-type, the second conductivity type the N-type, and the MOSFET a PMOS transistor.

The semiconductor substrate 101 may be made of a semiconductor wafer, for example a silicon wafer. A semiconductor layer 111 may be located over the semiconductor substrate 101, for example, an epitaxial layer 111 of the first conductivity type (N-EPI). The epitaxial layer 111 have preferably a doping level lower than the doping level of the semiconductor substrate 101.

The lower face 101A of the semiconductor substrate 101 is coupled to a load, for example a battery 10 having a VBAT output voltage.

A semiconductor layer 103 (N-LAYER) of the first conductivity type is located over the semiconductor substrate 101. The semiconductor layer 103 may be a part of the epitaxial layer 111 formed over the substrate 101, or may be another epitaxial layer. The semiconductor layer 103 may be referred to as a drift layer. The semiconductor layer 103 has preferably a doping level lower than the doping level of the semiconductor substrate 101.

The semiconductor layer 103 is isolated from the substrate 101, or from the epitaxial layer 111, by an isolation semiconductor layer 102 (P-RING) of the second conductivity type, the P-type in the example of Figures 1A-1C. The isolation semiconductor layer 102 is preferably a buried region, and may be referred to as a semiconductor ring, or as a ring, a P-ring in the example of Figures 1A-1C.

The isolation semiconductor layer 102 may form an isolation region for the battery 10.

The semiconductor layer 103 has an upper face 103A corresponding to the upper face of the MOSFET structure 100.

Semiconductor regions are located in the semiconductor layer 103 from the upper face 103A of the semiconductor layer 103. The semiconductor regions comprise:
- a source region S comprising a body region 104 (P-BODY) of the second conductivity type, a source contact region 105 (N+/S) of the first conductivity type and a contact region 106 (P+) of the second conductivity type, the source contact region 105 and the contact region 106 being positioned at a top portion of the body region 104 and flush with the upper face 103A of the semiconductor layer 103; a single contact (not shown) is formed extending on both contact regions 105 and 106 to place the body region 104 at the same potential as the source contact region 105; and
- a drain region D comprising a low doped drain region 107 (LDD) of the first conductivity type, and a drain contact region 108 (N+/D) of the first conductivity type positioned at a top portion of the LDD region 107 and flush with the upper face 103A of the semiconductor layer 103; the drain region D also includes at least a portion 109 of the semiconductor layer 103 which is between the LDD region 107 and the body region 104.

The body region 104 and the contact region 106 are coupled together, being of the same (second) conductivity type.

The channel formation region Ch, or channel region, is formed in the body region 104 between the semiconductor layer 103 and the source contact region 105. The channel region Ch is thus of the second conductivity type.

The source, drain and channel regions S, D, Ch form parts of a MOSFET of the MOSFET structure 100 that may include other transistors. The gate G of the MOSFET is a vertical gate having a gate region 124 in a trench 120, as detailed below.

The body region 104 is formed from the upper face 103A of the semiconductor layer 103.

The contact region 106 has a doping level higher than the doping level of the body region 104. The contact region 106 may form an electric contact for the body region 104, and may be referred to as a body contact region 106. The LDD region 107 has a doping level lower than the doping level of the drain contact region 108.

In the illustrated example, the source contact region 105 is positioned between the body contact region 106 and the drain contact region 108, but other configurations may be contemplated by those skilled in the art.

The MOSFET structure 100 comprises a trench 120, or inner trench, in which the gate region 124 of the MOSFET is formed, as illustrated in Figure 1B.

In Figures 1A, 1B and 1C, one MOSFET and one trench 120 are represented in the MOSFET structure 100, but such a MOSFET structure generally comprises a plurality of MOSFETs, two MOSFETs being separated by a trench 120 including a gate region 124. The MOSFETs may be separated by the trenches 120 in the Y direction. The same layout of MOSFETs and trenches may be repeated in the X direction.

The areas of the semiconductor layer 103 that are delimited by the trenches 120 form the active areas of the MOSFETs.

As illustrated in Figure 1B, a conductive element 121 is located in the trench 120. The conductive element 121 comprises, preferably is made of, a metallic material or, preferably, doped polysilicon. The width of the conductive element 121, taken in the width direction of the trench 120, is for example in the range from 30 nm to 400 nm, for example equal to around 300 nm. Preferably, the conductive element 121 is a conductive wall located in a central portion of the trench 120, the conductive wall extending in the same direction as the trench 120. The conductive element 121 may be referred to as a Field Plate (FP).

The conductive element 121 is surrounded by an insulating layer 122. The insulating layer 122 at least isolates the conductive element 121 from the semiconductor layer 103. The thickness of the insulating layer 122 is for example in the range from 100 nm to 200 nm, for example equal to around 150 nm. As an example, the insulating layer 122 is made of silicon oxide or of silicon nitride.

At the bottom end 120B of the trench 120, an insulating portion 123, preferably a portion of the insulating layer 122, is located under the conductive element 121. This insulating portion 123 also insulates the conductive element 121 from the semiconductor layer 103 located under the conductive element 121. The thickness of the insulating portion 123 is preferably similar to that of the insulating layer 122.

As illustrated in Figure 1B, in a portion of the trench 120 that is beside the body region 104 in the Y direction, a gate region 124 is positioned over the conductive element 121 in the trench 120. The gate region 124 comprises at least one electric conductor such as, for example, a metal and/or doped polysilicon. The gate region 124 extends up to the upper end 120A of the trench 120.

The gate region 124 is surrounded by a gate insulating layer 125 which at least isolates the gate region 124 from the body region 104 and generally also from the semiconductor layer 103. The gate insulating layer 125 is typically formed of one or a plurality of dielectric layers, for example, the gate insulating layer 125 is formed of a silicon oxide layer. The thickness of the gate insulating layer 125 is typically smaller than 50 nm, for example in the range from 5 to 40 nm, for example equal to around 35 nm.

Further, an insulating portion or layer 126, preferably of same thickness and of same material as the gate insulating layer 125, insulate the conductive element 121 from the gate region 124 in the trench 120.

In another portion of the trench 120 that is beside the LDD region 106 in the Y direction, no gate region is positioned over the conductive element 121 in the trench 120, and the conductive element 121 extends up to the upper end 120A of the trench 120.

A semiconductor well 112 (P-WELL) of the second conductivity type couples the semiconductor ring 102 to the upper face 103A of the semiconductor layer 103 through another body region 104' and another body contact region 106', to form an electrical connection of the semiconductor ring 102.

The body region 104' and the body contact region 106' are coupled to each other, being of the same (second) conductivity type, and are both placed to same potential as that of the isolation semiconductor layer 102 (P-ring).

A connection circuit 113, formed by the semiconductor ring 102, the semiconductor well 112, the body region 104' and the body contact region 106', is represented in Figure 1A and 1C between the semiconductor ring 102 and the upper face 103A of the semiconductor layer 103.

The trench 120 illustrated in Figure 1B extends horizontally in the X direction.

The MOSFET structure 100 may comprise another trench 120' extending horizontally in the Y direction, as illustrated in Figures 1A and 1C. The trench 120' may be a prolongation of the trench 120. As described for the portion of the trench 120 which is beside the LDD region 106, the trench 120' is only filled with a conductive element 121', an insulating layer 122' around the conductive element 121' and an insulating portion 123' under the conductive element 121'. The conductive element 121', the insulating layer 122' and the insulating portion 123' may be prolongations of respectively the conductive element 121, the insulating layer 122 and the insulating portion 123 of the trench 120.

The trench 120' may extend through the body region 104', the contact region 106' and the semiconductor layer 103 between the semiconductor well 112 and the source and drain regions S and D.

As represented in Figure 1A and 1C, the stacking of the semiconductor layer 103 of the first conductivity type, the semiconductor ring 102 of the second conductivity type and the substrate 101/epitaxial layer 111 of the first conductivity type forms a parasitic bipolar transistor BT, here an NPN bipolar transistor. The base B of the parasitic bipolar transistor BT is formed in the semiconductor ring 102, and thus is coupled to the upper face 103A of the semiconductor layer 103 through the connection circuit 113, the emitter E of the parasitic bipolar transistor BT is coupled to the drain terminal of the MOSFET, and the collector C of the parasitic bipolar transistor BT is connected to the substrate 101, and thus is coupled to the battery 10.

Another parasitic bipolar transistor BT', here an PNP bipolar transistor, is formed in the stacking of the body region 104 of the second conductivity type, the semiconductor layer 103 of the first conductivity type, and the semiconductor ring 102 of the second conductivity type.

The inventors have observed that, due to the parasitic bipolar transistor BT, and in a lesser extend to the parasitic bipolar transistor BT', the MOSFET structure 100 of Figures 1A to 1C had performances which were below the targeted performances. In particular, in some configurations, the performances of the MOSFET structure 100 in terms of drain output current density (JOUT), output battery voltage (VBAT), drain to source voltage, drain to P-ring voltage or source to P-ring voltage, could be below targeted values. For example, the targeted drain output current density JOUT is about 40A/mm², the targeted output battery voltage is about 28V and the targeted drain to source voltage is about 40V.

In a first configuration illustrated in Figure 1A, the semiconductor ring 102 is coupled to the source region S through the connection circuit 113 and the contact regions 105, 106 (through a common contact) of the source region S.

In the first configuration, the inventors have observed that, in a normal operation of the MOSFET that is, for the N-type, when the current circulates from the drain D to the source S, the performances in terms of drain to source voltage and drain to P-ring voltage are correct. However, in a current-recirculation operation of the MOSFET, that is, for the N-type, when the current circulates from the source S to the drain D (using the power of the battery 10), the parasitic bipolar transistor BT triggers and the performances are degraded. When the gate is off (OFF-state), that is, when the gate is deactivated, the battery output voltage VBAT cannot reach the target, being limited by the maximum voltage of the parasitic bipolar transistor BT, and when the gate is on (ON-state), that is, when the gate is activated, the drain output current density JOUT cannot reach the target.

The gate is said to be activated when a conduction channel is formed between the drain D and the source S. The gate is said to be deactivated when no conduction channel is formed between the drain D and the source S.

Figure 2 shows targeted and measured curves representing the drain output current density (JOUT (A/mm²)) of the MOSFET structure 100 of Figure 1A as a function of the output battery voltage (VBAT(V)) when the MOSFET structure 100 operates in a current-recirculation operation. Curve 201 is the targeted curve, and curve 202 is the measured curve.

The measured curve 202 of Figure 2 shows that, at 25°C, the trade-off between the drain output current density JOUT and the battery output voltage VBAT makes it impossible to reach the targeted drain output current density JOUT (JOUT TGT) of 40 A/mm² if the battery output voltage VBAT is higher than 20V. Conversely, it is impossible to reach the targeted output battery voltage (VBAT TGT) of 28V if the drain output current density JOUT is higher than about 28 A/mm².

In a second configuration illustrated in Figure 1C, the semiconductor ring 102 is coupled to the drain region D through the connection circuit 113.

In the second configuration, the inventors have observed that, in the current-recirculation operation of the MOSFET, that is, for the N-type, when the current circulates from the source S to the drain D, the performances are acceptable when the gate is on (ON-state). The parasitic bipolar transistor BT does not trigger. However, the performance are degraded when the gate is off (OFF-state). In the normal operation of the MOSFET, that is, for the N-type, when the current circulates from the drain D to the source S, the parasitic bipolar transistor BT' triggers and the performances are degraded, for example the drain to source voltage cannot reach the targeted voltage.

Those skilled in the art could have solved this problem by decreasing the gain of the parasitic bipolar transistor BT. One of the easiest and most used solution to do so is to increase its base doping acting on implants, and/or reducing its base access resistance. However, the base doping, that is doping of the semiconductor ring 102, is already high and may lead to a decrease of the breakdown voltage of the MOSFET.

An alternative solution that could be encompassed by those skilled in the art would be to decrease the doping of the epitaxial layer 111 and/or the semiconductor layer 103. However, this solution would increase the vertical on-state drain-source resistance (Rdson) of other semiconductor devices such as vertical diffusion MOSFETs (VDMOS) formed on/in the same semiconductor substrate, and in which the current flows vertically from the battery, that is the drain, to the source at the upper face 103A of the semiconductor layer 103. More generally, the trade-off between the performances and the fabrication of the MOSFET and that of other semiconductor components on/in the same semiconductor substrate may then be difficult to achieve or may induce high supplementary fabrication costs.

The inventors propose a MOSFET structure that makes it possible to address the problem described above, and to overcome all or part of the drawbacks of the known MOSFET structures. In particular, the inventors propose a MOSFET structure that makes it possible to manage the parasitic bipolar transistor issues.

Embodiments of MOSFET structures will be described below. The embodiments described are non-limiting and various variants will become apparent to those skilled in the art from the indications in this description.

The embodiments provide an electronic circuit integrated in a MOSFET structure comprising at least a MOSFET. In particular, the integrated electronic circuit and the MOSFET share a same semiconductor substrate. The MOSFET is referred in the following disclosure to as a main MOSFET.

The integrated electronic circuit may comprise one or a plurality of semiconductor components.

The MOSFET includes a semiconductor isolation region that forms a base of a parasitic bipolar transistor with the semiconductor substrate and with another semiconductor region or layer. The semiconductor isolation region for example isolates the semiconductor substrate of a first conductivity type from the MOSFET's active area of the first conductivity type, the semiconductor isolation region being a semiconductor isolation region of the second conductivity type opposite the first conductivity type.

For example, the MOSFET's active area is formed in a semiconductor layer of the first conductivity type.

The integrated electronic circuit is capable of overcoming the negative effects of the parasitic bipolar transistor on the performances of the main MOSFET. The assembly of the main MOSFET and the integrated electronic circuit forms at least part of a semiconductor structure, referred to as the MOSFET structure.

The main MOSFET may be a lateral diffusion MOSFET (LDMOS). In a LDMOS structure, the main MOSFET may be formed in a semiconductor layer of a first conductivity type and may be isolated from a semiconductor substrate of the first conductivity type by a semiconductor isolation region of the second conductivity type, such that a parasitic bipolar transistor is formed.

The LDMOS may be a trench LDMOS, or TLDMOS, in which the gate is a vertical gate in a trench.

The MOSFET may be a plurality of MOSFETs, for example, regrouped in a transistor cell.

The integrated electronic circuit is configured to:
- couple the base of the parasitic bipolar transistor, that is, the semiconductor isolation region, to the drain of the MOSFET in a reverse-conducting operation of the MOSFET; and
- couple the base of the parasitic bipolar transistor, that is, the semiconductor isolation region, to the source of the MOSFET in a normal operation of the MOSFET.

Preferably, the base of the parasitic bipolar transistor is connected to the semiconductor isolation region.

For example, the integrated electronic circuit is configured to detect if the gate of the MOSFET is activated or is deactivated, and to
- couple the base of the parasitic bipolar transistor to the drain of the MOSFET if the gate is activated (activated state, or ON state); and
- couple the base of the parasitic bipolar transistor to the source of the MOSFET if the gate is deactivated (deactivated state, or OFF state).

In a preferred embodiment, the integrated electronic circuit comprises an auxiliary MOSFET, similar to the main MOSFET, and a resistance R. The gate of the auxiliary MOSFET is coupled to, or is common with, the gate of the main MOSFET, and the drain of the auxiliary MOSFET is coupled to the drain of the main MOSFET. The source of the auxiliary MOSFET is coupled to the semiconductor isolation region, which is common to the main and auxiliary MOSFETs, through the resistance R.

The resistance R is preferably higher than the resistance of the main MOSFET in the activated state, for example higher than the on-state drain-source resistance (Rdson), and is lower than the resistance of the MOSFET in the deactivated state, for example lower than the off-state drain-source resistance (Rdsoff) of the main MOSFET. For example, the resistance R is comprised between 100Ω and 100kΩ.

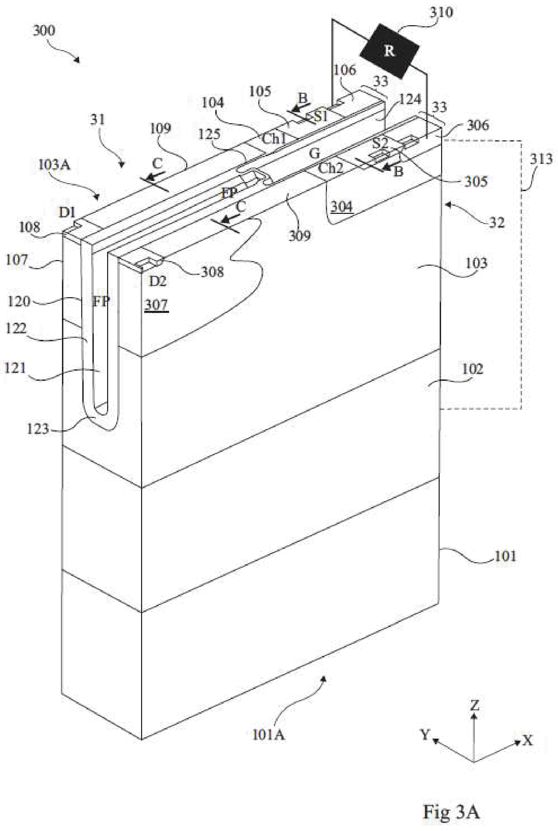

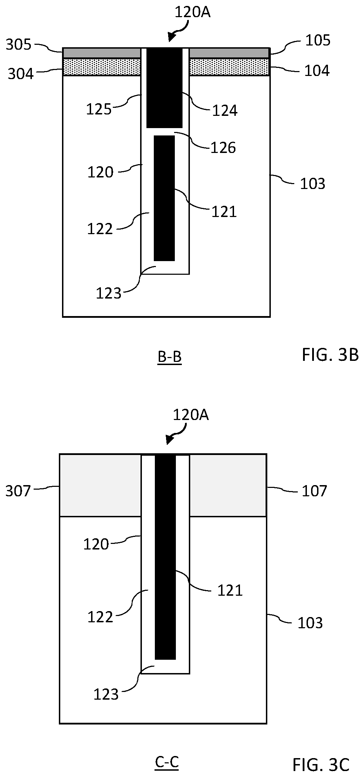

Figure 3A is a three-dimensional view partially illustrating a detail of a MOSFET structure 300 according to an embodiment. Figure 3B and Figure 3C are different cross-sections views illustrating an inner trench of the MOSFET structure of Figure 3A. Figures 3B and 3C have respective cross-section plans B-B, C-C shown in Figure 3A.

Figures 3A to 3C show an integrated electronic circuit comprising an auxiliary MOSFET 32, similar to a main MOSFET 31, and a resistance 310 (R).

The MOSFET structure 300 of Figure 3A has common elements with the MOSFET structure 100 of Figures 1A to 1C. These common elements have the same references signs. In particular, the MOSFET structure 300 of Figure 3A is a trench lateral diffusion MOSFET (TLDMOS) structure, and is formed on, and in, a semiconductor substrate 101 similar to the semiconductor substrate 101 of Figures 1A and 1C. The semiconductor substrate 101 is of a first conductivity type. The semiconductor substrate 101 may be made of a semiconductor wafer, for example a silicon wafer. The semiconductor substrate 101 may comprise a layer located over the semiconductor wafer, for example, an epitaxial layer of the first conductivity type having a doping level lower than the doping level of the semiconductor substrate 101 (not shown but may be similar to the epitaxial layer 111 of Figures 1A and 1C).

As in Figures 1A to 1C, the MOSFET structure 300 of Figure 3A is a NMOS transistor, the first conductivity type is the N-type and the second conductivity type is the P-type. In a variant, the first conductivity type could be the P-type, the second conductivity type the N-type, and the MOSFET a PMOS transistor, as described below.

As in Figures 1A to 1C, the lower face 101A of the semiconductor substrate 101 may be coupled to a load, for example a battery having a VBAT output voltage.

As in Figures 1A to 1C, a semiconductor layer 103 of the first conductivity type is located over the semiconductor substrate 101. The semiconductor layer 103 may be a part of an epitaxial layer above the semiconductor substrate 101, or another epitaxial layer, and may be referred to as a drift layer. The semiconductor layer 103 has preferably a doping level lower than the doping level of the semiconductor substrate 101. The semiconductor layer 103 is isolated from the substrate 101 by a semiconductor layer 102 of the second conductivity type. The semiconductor layer 102 may be referred to as a semiconductor ring, or as a ring, a P-ring in the example of Figure 3A. The semiconductor layer 103 has an upper face 103A corresponding to the upper face of the MOSFET structure 300.

The MOSFET structure 300 comprises a main MOSFET 31 which is for example similar to the MOSFET structure 100 of Figures 1A-1C, the common elements having the same reference signs. The main MOSFET 31 comprises semiconductor regions located in the semiconductor layer 103 from its upper face 103A.

As for the MOSFET structure 100 of Figures 1A-1C, the semiconductor regions of the main MOSFET 31 comprise:
- a source region S1 comprising a body region 104 of the second conductivity type, a source contact region 105 of the first conductivity type and a contact region 106 of the second conductivity type, the source contact region 105 and the contact region 106 being positioned at a top portion of the body region 104 and flush with the upper face 103A of the semiconductor layer 103; a single contact (not shown) is preferably formed extending on both contact regions 105 and 106 to place the body region 104 at the same potential as the source contact region 105; and
- a drain region D1 comprising a low doped drain (LDD) region 107 of the first conductivity type and a drain contact region 108 of the first conductivity type, positioned at a top portion of the LDD region 107 and flush with the upper face 103A of the semiconductor layer 103; the drain region D1 also includes at least a portion 109 of the semiconductor layer 103 which is between the LDD region 107 and the body region 104.

The body region 104 is positioned at a top portion of the semiconductor layer 103, and the LDD region 107 reaches the upper face 103A of the semiconductor layer 103.

The contact region 106 has a doping level higher than the doping level of the body region 104. The contact region 106 may form an electric contact for the body region 104, and may be referred to as a body contact region 106. The LDD region 107 has a doping level lower than the doping level of the drain contact region 108.

The channel formation region Ch1, or channel region, of the main MOSFET 31 is formed in the body region 104 between the semiconductor layer 103 and the source contact region 105. The channel region Ch1 is thus of the second conductivity type.

In the illustrated example, the source contact region 105 is positioned between the body contact region 106 and the drain contact region 108, but other configurations may be contemplated by those skilled in the art.

The gate G of the main MOSFET 31 is a vertical gate having a gate region 124 in a trench 120 that is detailed below.

The MOSFET structure 300 further comprises an auxiliary MOSFET 32 that is similar to the main MOSFET 31. In particular, the auxiliary MOSFET 32 comprises:
- a source region (S2) comprising a body region 304 of the second conductivity type, a source contact region 305 of the first conductivity type and a contact region 306 of the second conductivity type, the source contact region 305 and the contact region 306 being positioned at a top portion of the body region 304 and flush with the upper face 103A of the semiconductor layer 103; a single contact (not shown) is preferably formed extending on both contact regions 305 and 306 to place the body region 304 at the same potential as the source contact region 305; and
- a drain region (D2) comprising a low doped drain (LDD) region 307 of the first conductivity type and a drain contact region 308 of the first conductivity type, positioned at a top portion of the LDD region 307 and flush with the upper face 103A of the semiconductor layer 103; the drain region D2 also includes at least a portion 309 of the semiconductor layer 103 which is between the LDD region 307 and the body region 304.

The contact region 306 has a doping level higher than the doping level of the body region 304. The contact region 306 may form an electric contact for the body region 304, and may be referred to as a body contact region 306. The LDD region 307 has a doping level lower than the doping level of the drain contact region 308.

The body region 304 is positioned at a top portion of the semiconductor layer 103, and the LDD region 307 reaches the upper face 103A of the semiconductor layer 103.

The channel formation region Ch2, or channel region, of the auxiliary MOSFET 32 is formed in the body region 304 between the semiconductor layer 103 and the source contact region 305. The channel region Ch2 is thus of the second conductivity type.

The trench 120 is located between the main MOSFET 31 and the auxiliary MOSFET 32. The gate region 124 in the trench 120 is common to the main MOSFET 31 and the auxiliary MOSFET 32. Therefore, the main MOSFET 31 and the auxiliary MOSFET 32 share the same gate G.

The areas of the semiconductor layer 103 that are delimited by the trench 120 form the active areas 33 of the main and auxiliary MOSFETs 31, 32.

Preferably the drain region D2 of the auxiliary MOSFET 32 is coupled to the drain region D1 of the main MOSFET 31.

The main MOSFET 31 and the auxiliary MOSFET 32 may be coupled to a same battery at the lower face 101A of the semiconductor substrate 101.

The semiconductor ring 102 is coupled to the source region S2 of the auxiliary MOSFET 32, for example through a connection circuit 313 that may be similar to the connection circuit 113 of Figure 1A and 1C between the semiconductor ring 102 and the upper face 103A of the semiconductor layer 103.

The source region S2 of the auxiliary MOSFET 32 is coupled to the source region S1 of the main MOSFET 31, and thus to the semiconductor ring 102, through a resistance 310 (R).

The resistance R is preferably comprised between the resistance of the main MOSFET 31 in the activated state (Rdson) and the resistance of the main MOSFET 31 in the deactivated state (Rdsoff).

As for the MOSFET structure 100 of Figures 1A-1C, a conductive element 121, that may be referred to as a Field Plate (FP), is located in the trench 120. The conductive element 121 comprises, preferably is made of, a metallic material or, preferably, doped polysilicon. The width of the conductive element 121, taken in the width direction of the trench 120, is for example in the range from 30 nm to 400 nm, for example equal to around 300 nm. Preferably, the conductive element 121 is a conductive wall located in a central portion of the trench 120, the conductive wall extending in the same direction as the trench 120. The conductive element 121 is surrounded by an insulating layer 122. The insulating layer 122 at least isolates the conductive element 121 from the semiconductor layer 103. The thickness of the insulating layer 122 is for example in the range from 100 nm to 200 nm, for example equal to around 150 nm. As an example, the insulating layer 122 is made of silicon oxide or of silicon nitride. At the bottom of the trench 120, an insulating portion 123, preferably a portion of the insulating layer 122, is located under the conductive element 121. This insulating portion 123 also insulates the conductive element 121 from the semiconductor layer 103 located under the conductive element 121. The thickness of the insulating portion 123 is preferably similar to that of the insulating layer 122.

As illustrated in Figure 3B, the gate region 124 is positioned between the body 104 and source contact 105 regions of the main MOSFET 31 and the body 304 and source contact 305 regions of the auxiliary MOSFET 32, and the gate region 124 over the conductive element 121 in the trench 120. The gate region 124 comprises at least one electric conductor such as, for example, a metal and/or doped polysilicon. The gate region 124 is surrounded by a gate insulating layer 125 which at least isolates the gate region 124 from the body 104, 304 and source contact 105, 305 regions, and generally also from the semiconductor layer 103. The gate insulating layer 125 is typically formed of one or a plurality of dielectric layers, for example, the gate insulating layer 125 is formed of a silicon oxide layer. The thickness of the gate insulating layer 125 is typically smaller than 50 nm, for example in the range from 5 to 40 nm, for example equal to around 35 nm.

The insulating layer 122 has preferably a thickness greater than that of the gate insulating layer 125.

Further, an insulating portion or layer 126, preferably of same thickness and of same material as the gate insulating layer 125, insulate the conductive element 121 from the gate region 124 in the trench 120.

As illustrated in Figure 3C, between the LDD region 107 of the main MOSFET 31 and the LDD region 307 of the auxiliary MOSFET 32, no gate region is positioned over the conductive element 121, which extends up to the upper end 120A of the inner trench 120.

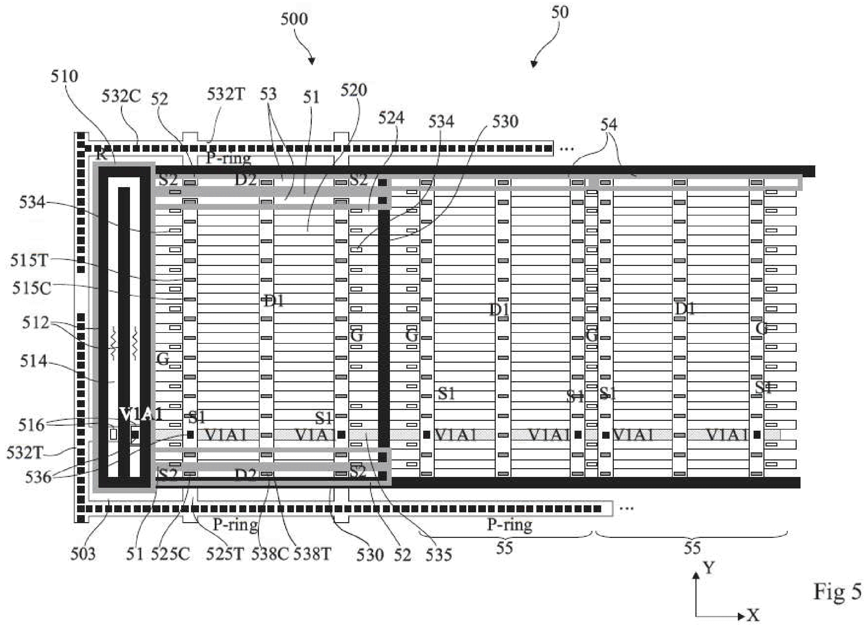

In Figure 3A, one main MOSFET 31, one auxiliary MOSFET 32 and one inner trench 120 between the main and auxiliary MOSFETs are represented in the MOSFET structure 300. The MOSFET structure 300 may comprise a plurality of main and/or auxiliary MOSFETs, two MOSFETs being separated by an inner trench 120 including a gate region 124. The MOSFETs may be separated by the trenches 120 in the Y direction. The same layout of MOSFETs and inner trenches 120 may be repeated in the X direction, as illustrated in Figure 5 and described below.

In the variant in which the first conductivity type would be the P-type, the second conductivity type the N-type, and each MOSFET a PMOS transistor, the semiconductor ring would be a N-ring, the parasitic bipolar transistor BT would be a PNP transistor, and the parasitic bipolar transistor BT' would be an NPN transistor. In the normal operation, the current would circulate from the source to the drain, whereas in the reverse-conducting operation, the current would circulate from the drain to the source. Similarly to what is previously described, the drain regions of the main and auxiliary MOSFETs would be coupled to each other, the gates of the main and auxiliary MOSFETs would be coupled to each other, the source of the auxiliary MOSFET would be coupled to the N-ring and the source of the main MOSFET would be coupled to the N-ring through the resistance R.

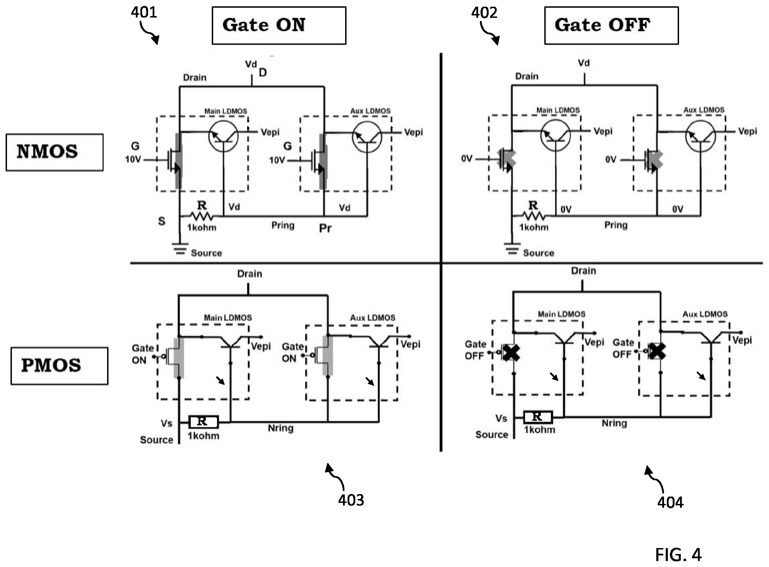

The functioning of the MOSFET structure 300 is now described in relation with Figure 4 below.

Figure 4 are circuit diagrams illustrating exemplary functioning of MOSFET structures according to embodiments.

Circuit diagrams 401 and 402 are directed to a N-type MOSFET, having a P-ring isolation region (Pring): circuit diagram 401 shows the reverse-conducting operation, when the gate is ON, and circuit diagram 402 shows the normal operation, when the gate is OFF.

Circuit diagrams 403 and 404 are directed to a P-type MOSFET, having a N-ring isolation region (Nring): circuit diagram 403 shows the reverse-conducting operation, when the gate is ON, and circuit diagram 404 shows the normal operation, when the gate is OFF.

The MOSFET structures in Figure 4 may be TLDMOS structures, similar to the TLDMOS structure of Figure 3A. The drain region of the auxiliary MOSFET (Aux LDMOS) is coupled to the drain region of the main MOSFET (Main LDMOS) and the gate of auxiliary MOSFET is coupled to, or is common with, the gate of the main MOSFET. The main MOSFET and the auxiliary MOSFET may be coupled to the same battery through the semiconductor substrate 101 having an output voltage Vepi.

The resistance R is for example 1 kΩ, which is a non-limitative value.

For the N-type, the source region of the auxiliary MOSFET is connected to the P-ring. The source region of the auxiliary MOSFET, and thus the P-ring, are coupled to the source region of the main MOSFET through the resistance R.

In the reverse-conducting operation, when the gate G is ON, that is a voltage, for example 10V, is applied to the gate, the current circulates from the source region to the drain region in the main MOSFET. Since the resistance R is higher than the Rdson of the main MOSFET, the P-ring cannot be coupled to the source S of the main MOSFET and the P-ring is thus connected to the drain D. Therefore, the parasitic bipolar transistor NPN is inhibited, and the performances of the main MOSFET in the reverse-conducting operation can be reached.

In the normal operation, when the gate G is OFF, no voltage is applied to the gate. The current circulates from the drain region to the source region in the main MOSFET. Since the resistance R is lower than the Rdsoff of the main MOSFET, the P-ring cannot be coupled to the drain D and the P-ring is thus connected to the source S of the main MOSFET. Therefore, the parasitic bipolar transistor PNP is inhibited, and the performances of the main MOSFET in the normal operation can be reached.

For the P-type, the source of the auxiliary MOSFET is connected to the N-ring. The source of the auxiliary MOSFET and the N-ring are coupled to the source of the main MOSFET through the resistance R.

In the reverse-conducting operation, when the gate G is ON, that is a voltage, for example 10V, is applied to the gate, the current circulates from the drain region to the source region in the main MOSFET. Since the resistance R is higher than the Rdson of the main MOSFET, the N-ring cannot be coupled to the source S of the main MOSFET and the N-ring is thus connected to the drain D. Therefore, the parasitic bipolar transistor PNP is inhibited, and the performances of the main MOSFET in the reverse-conducting operation can be reached.

In the normal operation, when the gate G is OFF, no voltage is applied to the gate, the current circulates from the source region to the drain region in the main MOSFET. Since the resistance R is lower than the Rdsoff of the main MOSFET, the N-ring cannot be coupled to the drain D, the N-ring is thus connected to the source S of the main MOSFET. Therefore, the parasitic bipolar transistor NPN is inhibited, and the performances of the main MOSFET in the normal operation can be reached.

Figure 5 is a top view illustrating a MOSFET structure 500 according to another embodiment and an electronic device 50 according to an embodiment.

The MOSFET structure 500 comprises two auxiliary MOSFET cells 52 and a plurality of main MOSFET cells 51 aligned with, and located between, the auxiliary MOSFETs 52 in the Y direction. Each main and auxiliary MOSFET cell may comprise one or a plurality of MOSFETs. In the example of Figure 5, each main and auxiliary MOSFET cell 51, 52 comprises two MOSFETs, which are LDMOS in this example, sharing a same drain region D1, D2. Each main MOSFET may be similar to the main MOSFET 31 of Figures 3A-3C. Each auxiliary MOSFET may be similar to the auxiliary MOSFET 32 of Figures 3A-3C.

Each main and auxiliary MOSFET cell 51, 52 comprises an active area 53 formed in a semiconductor layer 503 of the first conductivity type, similar to the semiconductor layer 103 of Figures 3A-3C. Similarly to the MOSFET structure 300 of Figures 3A-3C, the semiconductor layer 503 may be a part of an epitaxial layer of the first conductivity type formed over the semiconductor substrate, or another epitaxial layer of the first conductivity.

The semiconductor layer 503 is isolated from the semiconductor substrate by a semiconductor isolation layer of the second conductivity type, for example a semiconductor ring, referred to as a P-ring in Figure 5 which shows a P-ring connection track 532T and P-ring contacts 532C which are coupled to the P-ring.

Adjacent active areas 53 are separated, in the Y direction, by inner trenches 520 formed in the semiconductor layer 503 from its upper face. The active areas 53 and the inner trenches 520 are substantially elongated in the X direction. For example, the active areas 53 and the inner trenches 520 are strip-shaped, but other shapes of active areas and inner trenches can be contemplated by those skilled in the art.

In the example of Figure 5, there are sixteen active areas 53 separated by fifteen inner trenches 520, but other number of active areas and inner trenches can be contemplated by those skilled in the art.

The gates G of the main and auxiliary MOSFET cells 51, 52 are vertical gates comprising gate regions 524 in the inner trenches 520 between the source regions S1, S2 of the adjacent main and auxiliary MOSFETs in the Y direction, or between the source regions S1 of the adjacent main MOSFETs in the Y direction. Adjacent MOSFET cells in the Y direction, that is adjacent main MOSFET cells 51 or adjacent main and auxiliary 51, 52 MOSFET cells, share a same gate region 524. The gate regions 524 are coupled to gate contacts 534.

The drain regions D1 of the main MOSFET cells 51 and the drain regions D2 of the auxiliary MOSFET cells 52 are coupled to drain contacts 538C and are coupled to each other through a drain connection track 538T, for example at the second metallization level M2.

The source regions S1 of the main MOSFET cells 51 are coupled to main source contacts 515C and are coupled to each other through main source connection tracks 515T, for example at the second metallization level M2. The main source connection tracks 515T are coupled to a same source line 535, for example through vias 536 (VIAl) which are between the first metallization level M1 and the second metallization level M2.

The source regions S2 of the auxiliary MOSFET cells 52 are coupled to auxiliary source contacts 525C and are coupled to each other through auxiliary source connection tracks 525T, for example at the second metallization level M2. The auxiliary source connection tracks 525T are coupled to the P-ring connection track 532T and are isolated from the main source connection tracks 515T.

The resistance 510 (R) is an integrated diffused resistance. The resistance 510 is formed in a body region 514 (Pbody) of the second conductivity type, similar to the body regions 104, 304 of Figures 3A and 3B, and comprises trenches 512 formed in the body region 514 from the upper face of the body region 514, corresponding to the upper face of the semiconductor layer 503. The trenches 512 are preferably filled with field plates but no gate regions. The body region 514 is formed from the upper face of the semiconductor layer 503. Body contacts 516 are formed at the upper face of the body region 514. The body contacts 516 are coupled to the source line 535, and thus to the main source connection tracks 515T, through another via 536 (VIA1). The body contacts 516 are also coupled to the P-ring connection track 532T. Therefore, the source regions S1 of the main MOSFET cells 51 are coupled to the P-ring through the resistance 510.

The main and auxiliary MOSFET cells 51, 52 of the MOSFET structure 500 are surrounded by outer trenches 530. The outer trenches 530 are preferably filled with field plates but no gate regions.

The MOSFET structure 500 may be included in a larger electronic device 50. For example, as illustrated in Figure 5, the electronic device 50 comprises a plurality of columns 55 of other main MOSFETs 54, similar to the main MOSFETs 51, aligned with each other in the Y direction, without auxiliary MOSFETs. The MOSFET structure 500 may be separated from the other main MOSFETs 54 by one of the outer trenches 530.

In Figures 3A, 4 and 5, the integrated electronic circuit comprises at least one auxiliary LDMOS similar to the main LDMOS. This is a preferred solution, having the advantage of being easily integrable to the main MOSFET(s). However, this solution is not limitative and any other integrated electronic circuit configured to couple the base of the parasitic bipolar transistor to the drain of the main MOSFET in the reverse-conducting operation and couple the base of the parasitic bipolar transistor to the source of the MOSFET in the normal operation can be appropriate. For example, the integrated electronic circuit can comprise at least one bipolar transistor, or more generally, one or a plurality of transistors.

In Figure 5, the resistance R is a diffused resistance and a passive resistance. This solution is not limitative and any other resistance can be appropriate, for example an active resistance, such as a MOSFET or any other appropriate transistor.

The above described embodiments are particularly adapted to be used in any kind of industrial markets, in particular in industrial markets using power transistors. More particularly, the MOSFET structure according to the embodiments and the electronic device according to the embodiments can be intended for:
- the automotive industry, for example in the domain of car electrification or the domain of advanced driver assistance systems;
- the industrial industry, for example in the domain of green energy, in the domain of electrification of infrastructure, of the internet of things (IoT), and of smart homes, wherein power and energy consumption and the exchange of data are key element;
- the personal electronics industry, for example in the domain of mobile phone and of the internet of things (IoT), and in the domain of high speed-interface; and
- the communications equipment, computers and peripherals industry.

Various embodiments and variants have been described. Those skilled in the art will understand that certain features of these embodiments can be combined and other variants will readily occur to those skilled in the art. In particular, the examples are described with the first conductivity type being the N-type and the second conductivity type the P-type, the MOSFETs being NMOS transistors. This is not limiting, and those skilled in the art will be able to modify the structure for PMOS transistors, the first conductivity type being then the P-type and the second conductivity type the N-type. In addition, the examples are described with a MOSFET being a LDMOS, such as a TLDMOS. This is not limiting, and the embodiments may apply to other MOSFET structures, particularly lateral MOSFET structures having a planar gate.

Finally, the practical implementation of the embodiments and variants described herein is within the capabilities of those skilled in the art based on the functional description provided hereinabove.

## Claims

1. A MOSFET structure (300; 500) formed on and in a semiconductor substrate (101), the MOSFET structure comprising:
- a main MOSFET (31; 51) including a semiconductor isolation region (102) forming a base of a parasitic bipolar transistor (BT) with the semiconductor substrate and another semiconductor region or layer of the main MOSFET;
- an integrated electronic circuit (32, 310; 52, 510) configured to:
couple the semiconductor isolation region (102) to a drain region (D1) of the main MOSFET in a reverse-conducting operation of the MOSFET; and
couple the semiconductor isolation region (102) to the source region (S1) of the main MOSFET in a normal operation of the MOSFET.

2. The MOSFET structure (300; 500) according to claim 1, wherein the integrated electronic circuit (32, 310; 52, 510) is configured to detect if the gate of the main MOSFET is activated or deactivated, and to
- couple the semiconductor isolation region (102) to the drain region (D1) of the main MOSFET if the gate is activated; and
- couple the semiconductor isolation region (102) to the source region (S1) of the MOSFET if the gate is deactivated.

3. The MOSFET structure (300; 500) according to claim 1 or 2, wherein the semiconductor substrate (101) is of a first conductivity type, the semiconductor isolation region (102) is of the second conductivity type opposite the first conductivity type, and the MOSFET structure further includes a semiconductor layer (103; 503) of the first conductivity type, the semiconductor isolation region (102) being located between the semiconductor substrate (101) and the semiconductor layer (103), for example an active area (33; 53) of the main MOSFET is formed in the semiconductor layer (103; 503).

4. The MOSFET structure (300; 500) according to claim 3, further comprising at least one inner trench (120; 520) in the semiconductor layer (103; 503) from an upper face (103A) of the semiconductor layer, the gate of the main MOSFET (31; 51) being a vertical gate having a gate region (124; 524) isolated by a gate insulating layer (125) in the at least one inner trench.

5. The MOSFET structure (300; 500) according to claim 4, wherein the gate region (124; 524) is positioned over a conductive element (121), for example a field plate (FP), isolated by a first insulating layer (122, 123) in the inner trench (120) and isolated from the gate region by a second insulation layer (126).

6. The MOSFET structure (300; 500) according to any of claims 1 to 5, wherein the integrated electronic circuit comprises an auxiliary MOSFET (32; 52) and a resistance (310; 510), the gate (G) of the auxiliary MOSFET being coupled to, or being common with, the gate (G) of the main MOSFET, an auxiliary drain region (D2) of the auxiliary MOSFET being coupled to the drain region (D1) of the main MOSFET, an auxiliary source region (S2) of the auxiliary MOSFET being coupled to the semiconductor isolation region (102), and the source region (S1) of the main MOSFET being coupled to the semiconductor isolation region (102) through the resistance.

7. The MOSFET structure (300; 500) according to claim 6, wherein the resistance (310; 510) is comprised between the resistance of the main MOSFET (31; 51) in the activated state and the resistance of the main MOSFET in the deactivated state, for example the resistance is comprised between 100Ω and 100kΩ.

8. The MOSFET structure (300; 500) according to claim 6 or 7, wherein the auxiliary MOSFET (32; 52) is similar to the main MOSFET (31; 51), for example the main and auxiliary MOSFETs are lateral diffusion MOSFETs or trench lateral diffusion MOSFETs.

9. The MOSFET structure (300; 500) according to any of claims 6 to 8, wherein:
- the source region (S1) of the main MOSFET (31; 51) comprises a main body region (104) of the second conductivity type, and a main source contact region (105) of the first conductivity type in the main body region and flush with an upper face (103A) of the semiconductor layer (103);
- the drain region (D1) of the main MOSFET comprises a main low doped drain region (107) of the first conductivity type, and a main drain contact region (108) in the main low doped drain region and flush with the upper face of the semiconductor layer;
the main channel formation region (Ch1) of the main MOSFET (31) being formed in the main body region (104) and being of the second conductivity type;
- the auxiliary source region (S2) comprises an auxiliary body region (304) of the second conductivity type, and an auxiliary source contact region (305) of the first conductivity type in the auxiliary body region and flush with the upper face of the semiconductor layer;
- the auxiliary drain region (D2) comprises an auxiliary low doped drain region (307) of the first conductivity type, and an auxiliary drain contact region (308) in the auxiliary low doped drain region and flush with the upper face of the semiconductor layer; and
the auxiliary channel region (Ch2) of the auxiliary MOSFET (32) being formed in the auxiliary body region (304) and being of the second conductivity type.

10. The MOSFET structure (300; 500) according to any of claims 6 to 9, wherein the areas of the semiconductor layer (103; 503) that are delimited by the at least one inner trench (120; 520) form the active areas (33; 53) of the main (31; 51) and auxiliary (32; 52) MOSFETs.

11. The MOSFET structure (300; 500) according to any of claims 6 to 10, wherein the main MOSFET (31) and the auxiliary MOSFET (32) are coupled to a same battery at a lower face (101A) of the semiconductor substrate (101).

12. The MOSFET structure (300; 500) according to any of claims 6 to 11 in combination with claim 4 or 5, wherein the gate region (104; 504) is common to the main MOSFET (31; 51) and the auxiliary MOSFET (32; 52).

13. The MOSFET structure (500) according to any of claims 6 to 12, wherein the auxiliary MOSFET is a plurality of auxiliary MOSFETs (52) each extending in a first direction (X) substantially parallel to a plane (XY) of the semiconductor substrate (101), the main MOSFET is a plurality of main MOSFETs (52) extending in the first direction (X), the main MOSFETs being located between the auxiliary MOSFETs (52) in a second direction (Y) substantially orthogonal to the first direction (X) and substantially parallel to the plane (XY).

14. The MOSFET structure (500) according to any of claims 1 to 13, wherein the resistance (510) is an integrated diffused resistance.

15. An electronic device (50) comprising a semiconductor substrate (101) and at least one MOSFET structure (300; 500) according to any of claims 1 to 14 formed on and in the semiconductor substrate.

16. A method for using the MOSFET structure (300; 500) of any of claims 1 to 14, the using method comprising using the integrated electronic circuit (32, 310; 52, 510) for:
coupling the semiconductor isolation region (102) to the drain region (D1) of the main MOSFET in a reverse-conducting operation of the MOSFET; and
coupling the semiconductor isolation region (102) to the source region (S1) of the main MOSFET in a normal operation of the MOSFET.
